# EUROPEAN PATENT SPECIFICATION

(11) **EP 1 231 749 B1**
(45) Date of publication and mention of the grant of the patent: **01.02.2006**
(21) Application number: 01307439.8
(22) Date of filing: 31.08.2001
(51) Int. Cl.: H04L 25/06, H03K 5/007

(54) **Data slicer and RF receiver employing the same**
Daten-Slicer-Schaltung und RF-Empfänger, der diese Schaltung verwendet
Séparateur de données et utilisation dans un récepteur radiofréquence

(30) Priority: 02.02.2001 KR 2001005073
(43) Date of publication of application: 14.08.2002
(73) Proprietor: SAMSUNG ELECTRONICS CO., LTD., Suwon-City, Kyungki-do (KR)
(72) Inventor: Lee, Heung-bae, 606-406, Yoowon Apartment, Suwon-city, Kyungki-do (KR); Cho, Gea-ok, Poongduckcheon-ri, Suji-eup, Gyunggi-do (KR); Suh, Chun-deok, Yongin-city, Kyungki-do (KR)
(74) Representative: Chugg, David John

(56) References cited:
- GB-A- 2 333 214
- US-A- 5 900 749
- US-A- 5 933 455

## Description

The present invention relates to a data slicer and an RF receiver employing the data slicer.

Generally, an RF receiver performs demodulation in order to recover RF signals received from a transmitter into an original signal.

The RF receiver usually includes a low noise amplifier (LNA), a mixer, a demodulator, and a data slicer. Here, the demodulator outputs an analog signal containing information therein through the demodulation processes that are predetermined according to a corresponding communication method. The signal demodulated through the demodulator is compared with a reference voltage through the data slicer, and is generated as final digital data in the form of a pulse.

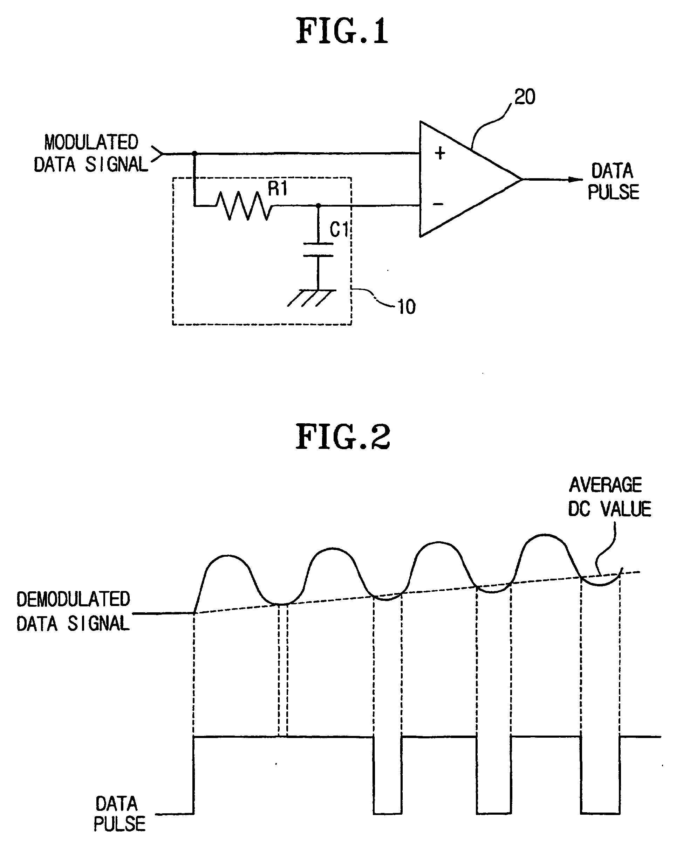

Figure 1 is a circuit diagram of a conventional data slicer.

Referring to Figure 1, the data slicer includes an average DC detector 10, and a comparator 20.

The average DC detector 10 includes a resistor R1 and a capacitor C1 connected to an input line for the demodulated signal. Operating as a low pass filter, the resistor R1 and the capacitor C1 detect the average DC value of the demodulated analog data input signal and outputs the same as a reference voltage.

The comparator 20 compares the demodulated input data with the average DC value detected by the average DC detector 10, and outputs the comparison result. The signal is outputted from the comparator 20 in the form of pulse data signal.

Meanwhile, there sometimes occurs a sudden variation of the DC component due to various causes such as distortion of the demodulated signal during transmission, mis-matching among the components, and channel interferences between the demodulated signals, or the like. If DC variation occurs, the average DC detector 10 cannot follow and respond to the varied DC value, since the average DC detector 10 uses a fixed RC time constant. As a result, since the conventional data slicer cannot detect the demodulated signal, or since a distortion is incurred in the duty of the pulse, the conventional data slicer cannot recover the signal properly.

More specifically, as shown in Figure 2, the data pulse obtained by a comparison between the demodulated signal having gradually increasing DC component and the average DC value detected by the DC detector 10, indicates both signal missing and distortion of the duty of the detected signal.

GB-A-233214 discloses a data slicer comprising means to use knowledge of the value of an input signal received on at least one clock cycle proceeding a current clock cycle, to estimate where in the period of a read signal a present sample value relates to, and means to provide an output signal using extrapolation of the proceeding values. A data recovery circuit provides correct phase alignment of signals. This document forms the precharacterising portion of the claims appended hereto.

US-A-5933455 discloses an FSK data slicer, used by a receiver circuit in a wireless telecommunication device for converting an analogue data signal to a digital data signal. The data slicer includes a low-pass filter, a controller, a comparator, and an integrator.

US-A-5900749 discloses an electronic circuit for use in applications such as a threshold detector for a radio signal data slicer. A low-pass filter is used to receive an analogue data signal and determines the threshold voltage by rejecting any signal-varying components of the analogue data signal, thereby averaging the signal.

Embodiments of the present invention aims to solve or reduce the above-mentioned problems of the related art, and accordingly, it is an aim of embodiments of the present invention to provide a data slicer, for accurately recovering a signal by deleting a DC offset component from a demodulated signal, and an RF receiver having the data slicer.

According to a first aspect of the present invention, a data slicer is provided that includes a sample signal output portion, for outputting a first sample signal by sequentially outputting samples of demodulated input signals that are sampled according to a predetermined sampling frequency, and outputting a second sample signal which is sampled at a predetermined time delayed from the first sample signal; and a data recovery portion for recovering the demodulated input signals into a DC offset component-deleted signal, by using the first and the second sample signals output from the sample signal output portion.

The sample signal output portion preferably includes a running clock generator for sequentially generating a running clock corresponding to the sampling frequency through a plurality of output channel, in which a cyclic period of the running clock is set by multiplying a predetermined number by a unit data interval of the demodulated input signals; a sampler synchronized with the respective running clocks output from the running clock generator, for sampling and holding the demodulated input signals; a first multiplexer for synchronizing the samples held by the sampler to the respective running clocks, and outputs the result as the first sample signal; and a second multiplexer for synchronizing the samples that are held by the sampler ahead of the samples output from the first multiplexer at a predetermined time interval, and outputting the result as the second sample signal.

The cyclic period of the running clocks output from the running clock generator at certain intervals is preferably two times larger than the unit data interval of the demodulated input signals.

The data recovery portion preferably recovers the demodulated input signals into a DC offset component-deleted signal by obtaining a difference signal from a difference between the first and the second sample signals, and inversing the difference signal, and comparing the inversed difference signal with the difference signal, and outputting a comparison result.

The data recovery portion preferably recovers the demodulated input signals into a DC offset component-deleted signal by obtaining a difference signal from a difference between the first and the second sample signals, and comparing the difference signal with a predetermined reference signal, and outputting a comparison result.

An RF receiver may be provided comprising: a demodulator for demodulating a received RF signal; and a data slicer according to the present invention for recovering a demodulated signal input from the demodulator into a pulse data signal.

For a better understanding of the invention, and to show how embodiments of the same may be carried into effect, reference will now be made, by way of example, to the accompanying diagrammatic drawings in which:
Figure 1 is a circuit diagram of a conventional data slicer;
Figure 2 is a waveform showing a data pulse generated by the data slicer of Figure 1 from an input demodulated data signal;
Figure 3 is a block diagram of an RF receiver in accordance with a preferred embodiment of the present invention;
Figure 4 is a block diagram showing one example of the data slicer of Figure 3;
Figure 5 is a waveform showing a running clock generated from the running clock generator of Figure 4;
Figure 6 is a circuit diagram for schematically showing the sampler of Figure 4;
Figure 7 is a circuit diagram for schematically showing the first multiplexer of Figure 4;
Figure 8 is a circuit diagram for schematically showing the second multiplexer of Figure 4;
Figure 9 is a circuit diagram for showing one example of the difference detector of Figure 4;
Figure 10 is a waveform for showing the demodulated data signal input to the data slicer of Figure 4 being output through the difference detector;
Figure 11 is a block diagram showing the data slicer in accordance with another preferred embodiment of the present invention; and
Figure 12 is a circuit diagram for showing one example of the difference detector of Figure 11.

The preferred embodiments of the present invention will now be described with reference to the accompanying drawings, while the like elements are given the same reference numerals throughout and any redundant explanation is omitted as possible.

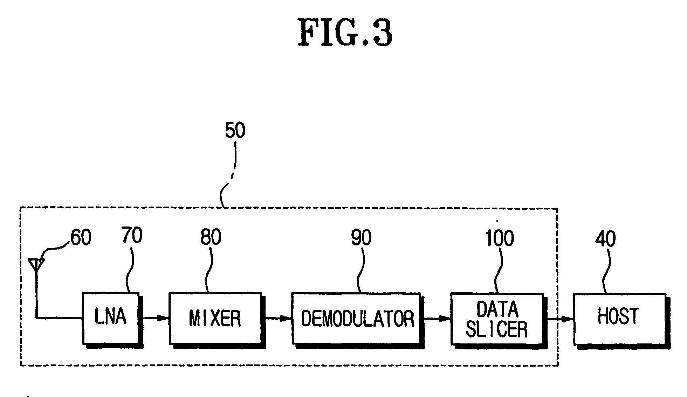

Figure 3 is a block diagram showing an RF receiver in accordance with one preferred embodiment of the present invention.

Referring to Figure 3, the RF receiver 50 includes a low noise amplifier 70 (LNA), a mixer 80, a demodulator 90 and a data slicer 100.

The LNA 70 amplifies the RF signal received through an antenna 60.

The mixer 80 mixes a frequency signal generated from an oscillator (not shown), for example, a voltage controlled oscillator (VCO), with the amplified RF signal.

The demodulator 90 demodulates the signal output from the mixer 80, and outputs the demodulated signal in the form of an analog signal containing information therein. Here, demodulation of the demodulator 90 is performed corresponding to a modulation method of a transmitter (not shown).

The data slicer 100 converts the signal demodulated by the demodulator 90 into a pulse digital signal, and outputs the converted signal to a host 40 where information is read.

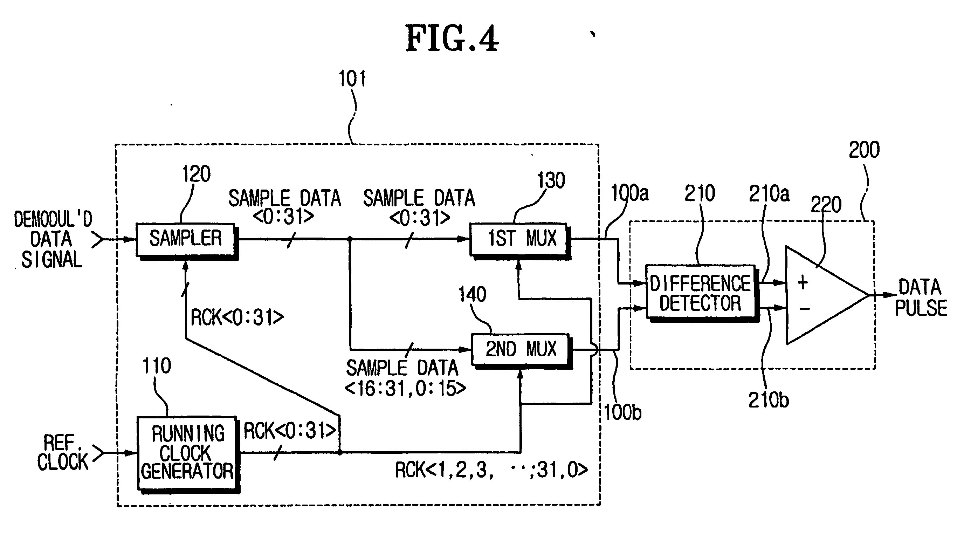

Figure 4 is a block diagram showing one example of the data slicer of Figure 3.

Referring to Figure 4, the data slicer 100 includes a sample data output portion 101, and a data recovery portion 200.

The sample data output portion 101 includes a running clock generator 110, a sampler 120, and a first and second multiplexers 130 and 140.

The running clock generator 110 sequentially generates running clocks (RCK) through respective output lines.

The running clock generator 110 generates the running clocks (RCK) by sequentially switching the reference clock, generated from a reference clock generator (not shown), through a plurality of output lines. Alternatively, the reference clock generator can be installed in the running clock generator 110.

Here, the frequency of the reference clock corresponds to the sampling rate of the demodulated signal in the unit data expressing interval. The unit data expressing interval is where bit signals 0 or 1 are recorded when information is expressed in the form of binary signal.

Further, with respect to determining the running clock generating interval that corresponds to the number of output lines of the running clock generator 110, it is preferable to determine the running clock generating interval to be an integral multiple of the unit data expressing interval. More specifically, the number of output channels for the running clocks generated from the running clock generator 110 are determined to be a certain number of samples that are obtainable in the two bit intervals according to the set sampling rate for the demodulated data input signals.

For example, when the demodulated data input signal has a transmission speed of 1Mbps, the reference clock of 16MHz is generated in order to obtain sixteen (16) samples for one bit.

Here, if the running clock generating interval is determined to be two bit intervals, the number of output channels of the running clock generator 110 becomes thirty-two (32). Also, during the running clock generating interval, the thirty-two running clocks (RCK0-RCK31) are output through the respective output lines, sequentially.

The connection between the output lines of the running clock generator 110 and the other elements, i.e., the sampler 120, the first multiplexer 130 and the second multiplexer 140 is represented by an order of the running clocks. Input of the running clocks generated from the running generator 110 into the respective elements will be described later.

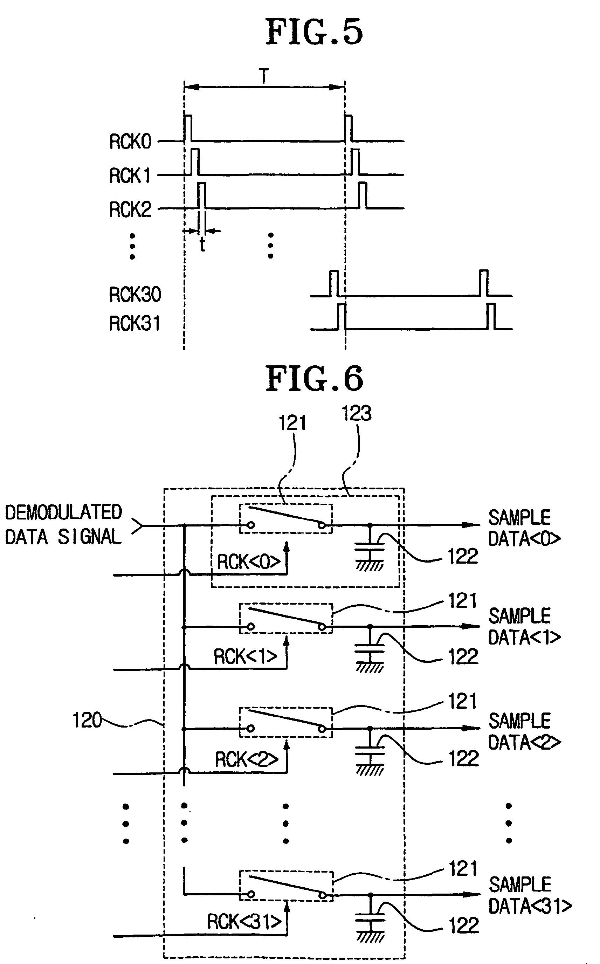

Figure 5 shows one example of the waveform of the thirty-two running clocks output from the running clock generator 110. In Figure 5, reference character 'T' refers to a running clock generating interval, and 't' is a width of the reference clock.

The sampler 120 sequentially performs sampling and holding of the demodulated analog input signals in synchronization with the running clock signals sequentially output from the running clock generator 110.

Figure 6 shows the example of the construction of the sampler 120.

Referring to Figure 6, the sampler 120 has a plurality of sampling/holding unit elements 123 which are connected to the input lines of demodulated signal in parallel. Each sampling/holding element 123 includes a switch 121 and capacitor 122. The number of the sampling/holding unit elements 123 corresponds to the number of running clocks.

The respective switches 121 are switched on by synchronization with the corresponding running clocks. That is, the respective switches perform sampling and holding corresponding to the thirty-two running clocks (RCK0-RCK31), which are sequentially output from the running clock generator 110. The switches 121 are switched on to perform sampling in a high state of the running clocks, and switched off to hold the samples in a low state.

More specifically, the switch 121, which is connected to the <0> order RCK output line, is switched on while the 0 order RCK (RCK<0>) is generated, and then switched off until the next period that the <0> order RCK (RCK<0>) is generated. In the same manner, the switches 121 connected to the RCK output lines in a predetermined order are synchronized with the RCK and switched on and off.

The switch 121 may be a transistor.

The first multiplexer 130 is connected to respective output ends of the sampler 120. The first multiplexer 130 has a plurality of switches commonly-connected to the output end thereof.

The first multiplexer 130 is constructed in such a manner that the respective switches thereof are synchronized with the RCK1, RCK2-RCK31, and RCK0 to output the samples held by the sampler 120. The respective switches of the first multiplexer 130 are connected to the running clock generator 110 so as to receive a running clock (RCK) that is one-clock shifted from the switch corresponding to the sampler 120.

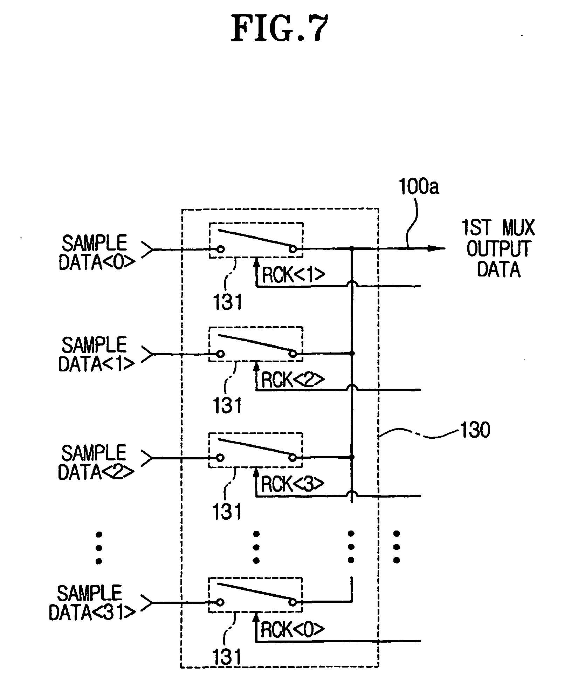

One example of the first multiplexer 130 is shown in Figure 7.

Referring to Figure 7, the switch 131 of the first multiplexer 130 connected to the sampling/holding unit element 123 of the sampler 120, which is synchronized with the RCK<0>, is operated to synchronize the sample data <0> sampled at the capacitor 122 with respect to the first running clock RCK<1>, and is switched on to output the result. In the same manner, the other switches 131 of the first multiplexer 130 are also operated to be switched on by being synchronized with the running clocks that are one-clock delayed from the running clocks applied to the switches 121 corresponding to the sampler 120.

The second multiplexer 140 is connected to the respective output ends of the sampler 120, and has a plurality of switches commonly-connected to an output end 100b thereof.

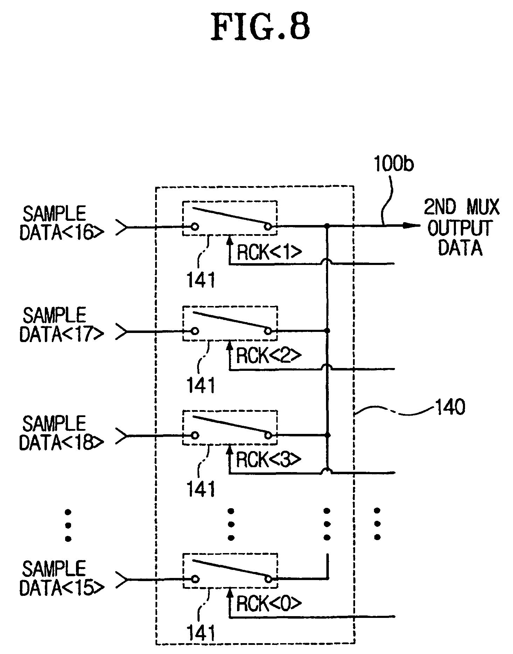

The second multiplexer 140 is constructed in a manner such that the respective switches thereof are synchronized with the running clock signals (RCK1, RCK2-RCK31, and RCKO), to output the samples held by the sampler 120. The respective switches of the second multiplexer 140 are connected such that the switches receive the running clocks (RCK) by the same order as the first multiplexer 130. Further, input ends of the switches of the second multiplexer 140 are connected to the sampler 120 to receive the sample signals that are sixteen (16) clock-delayed from the first multiplexer 130. That is, as shown in Figure 8, the switch 141 of the second multiplexer 140 synchronized with the first running clock (RCK<1>), is connected to the sampler 120 in order to switch and output the sixteenth sample data that is sampled by the sixteenth switch 121 of the sampler synchronized with the sixteenth running clock (RCK<16>). Accordingly, upon receipt of the first running clock (RCK<1>), the first switch 141 of the second multiplexer 140 outputs the sixteenth sample data. In the same manner, the other switches 141 of the second multiplexer 140 are connected to the sampler 120 in order to output the sample data that are sixteen clock-delayed from the sample data output from the first multiplexer 130.

Accordingly, when one running clock (RCK) is output, the signal output from the second multiplexer 140 is the signal that is delayed from the signal output from the first multiplexer 130, by sixteen clocks, i.e., by a unit data expressing interval (2/T).

The data recovery portion 200 includes a difference detector 210 and a comparator 220.

The difference detector 210 outputs a signal for a difference between two signals output from the output lines 100a and 100b of the first and the second multiplexers 130 and 140, and an inverse signal of the difference signal through output ends 210a and 210b thereof that correspond to the first and the second multiplexers 130 and 140.

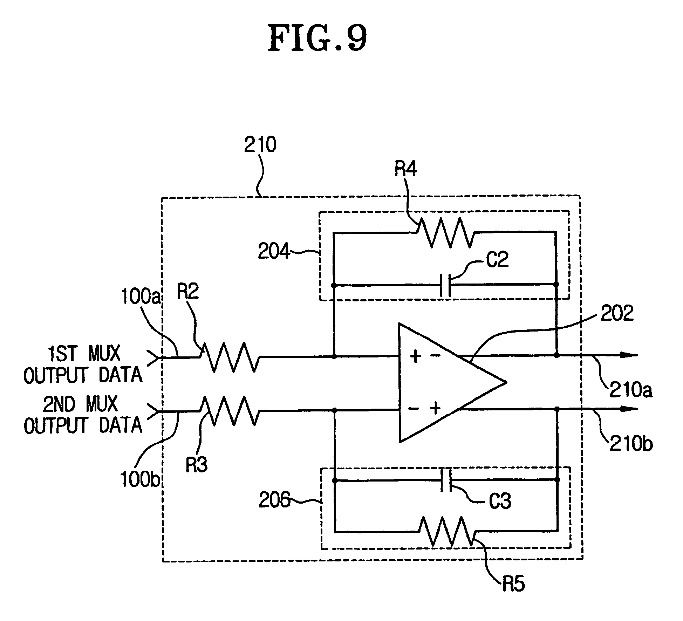

An exemplary construction of the difference detector 210 is shown in Figure 9.

Referring to Figure 9, the difference detector 210 includes resistors R2 and R3, an OP-amp 202, and RC parallel circuits 204 and 206.

The resistor R2 is connected between the output line 100a of the first multiplexer 130 and a non-inverse input terminal (+) of the OP-amp 202.

The resistor R3 is connected between the output line 100b of the second multiplexer 140 and an inverse input terminal (-) of the OP-amp 202.

The RC parallel circuit 204, in which the resistor R4 and the capacitor C2 are interconnected in parallel, is connected between the non-inverse input terminal (+) and the inverse input terminal (-) of the OP-amp 202.

Further, the RC parallel circuit 206, in which the resistor R5 and the capacitor C3 are interconnected in parallel, is connected between the inverse input terminal (-) and the non-inverse output terminal (+) of the OP-amp 202.

From the respective output ends 210a and 210b of the difference detector 210, the difference between the signals output from the first and the second multiplexers 130 and 140, and the signal of the inversed difference are output, respectively.

Then as such demodulated signals pass through the difference detector 202, the DC component is deleted from the demodulated signal.

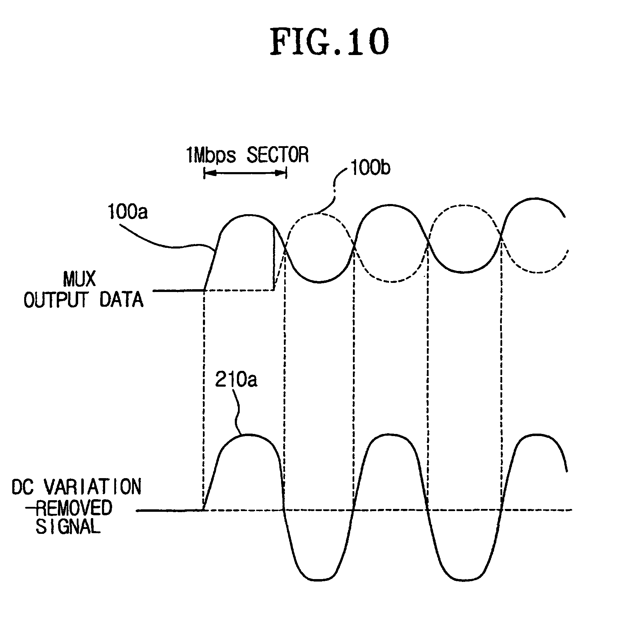

That is, as shown in Figure 10, from a first signal 100a1 (solid line) that is output through the first multiplexer 130, by subtracting a second signal 100b1 (dotted line) that is output through the output line 100b of the second multiplexer 140 and that corresponds to a value delayed from the first signal 100a1 by the unit data expressing interval, the DC component is deleted from the first signal 100a1 and the DC-deleted signal 210a1 is output through the output end 210a of the difference detector 210. Through the other output end 210b of the difference detector 210, an inversed signal (not shown) of the DC-deleted signal 210al is output.

The comparator 220 compares the DC-deleted signal 210a1 with the inversed signal output from the difference detector 210, and outputs the comparison result. When the DC-deleted signal 210a1 and its inversed signal are compared by the comparator 220, a pulse signal having an amplitude two times larger than the difference is output. Accordingly, data is determined by the host 40 more easily.

The operation of the data slicer 100 is now described in greater detail.

When the 0 order running clock (RCK<0>) is generated from the running clock generator 110, the sampler 120 is synchronized with the zero order running clock (RCK<0>), and samples and holds the zero (0) order sample. Next, when the next order running clock, i.e., when the first running clock (RCK<1>) is generated, the sampler 120 is synchronized with the first running clock (RCK<1>) and samples and holds the first order sample. Simultaneously, the switch of the first multiplexer 130, which is synchronized with the first running clock (RCK<1>), outputs the zero order sample data, which is sampled and held, in response to the previous running clock, i.e., the zero order running clock (RCK<0>). Further, the switch 141 of the second multiplexer 140 synchronized with the first running clock (RCK<1>) outputs the sixteenth sample data, which is sampled and held, in response to the running clock sixteen clocks ahead of the first running clock (RCK<1>), i.e., in response to the sixteenth running clock (RCK<16>).

Accordingly, the signal output through the second multiplexer 140 corresponds to the signal the sixteen clock-delayed from the signal output through the first multiplexer 130. That is, the signals simultaneously output from the first and the second multiplexers 130 and 140 are sixteen clocks away from each other. Accordingly, by subtracting the signal of the second multiplexer 140 from the signal of the first multiplexer 130, the DC component is deleted from the demodulated signal.

Meanwhile, the difference detector 210 outputs the DC-deleted signal and its inversed signal, respectively.

Accordingly, the comparator 220 outputs a waveform of the pulse signal, which corresponds to the comparison result between the DC-deleted signal and the inversed signal.

That is, the comparator 220 recovers the DC-deleted demodulated signal into a pulse digitalized signal.

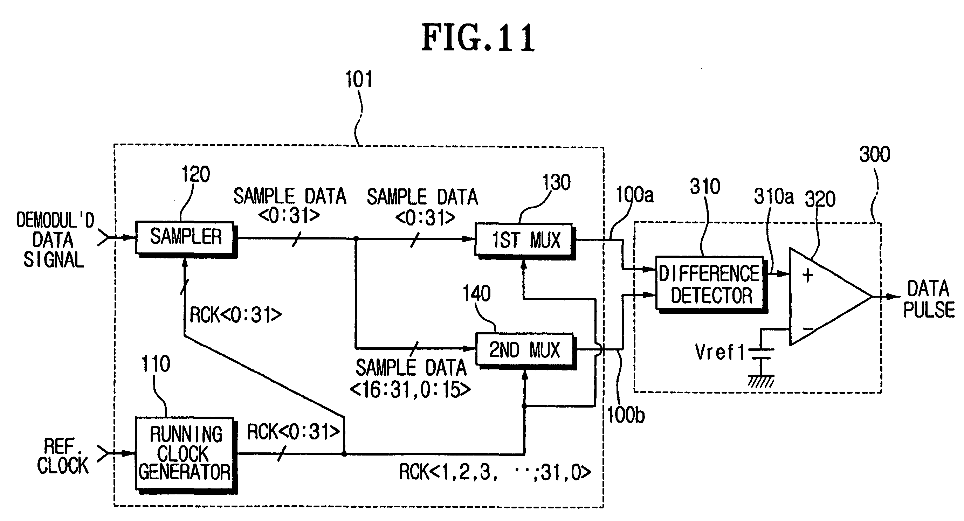

Figure 11 is a block diagram of the data slicer in accordance with another preferred embodiment of the present invention.

Throughout the description of another preferred embodiment, the like elements will be referred to by the same reference numerals.

Referring to Figure 11, the data slicer includes a sample data output portion 101, and a data recovery portion 300.

The data recovery portion 300 includes a difference detector 310 and a comparator 320.

The difference detector 310 outputs a signal for a difference between the signal output from output line 100a of the first multiplexer 130 and the signal output through the output line 100b of the second multiplexer 140.

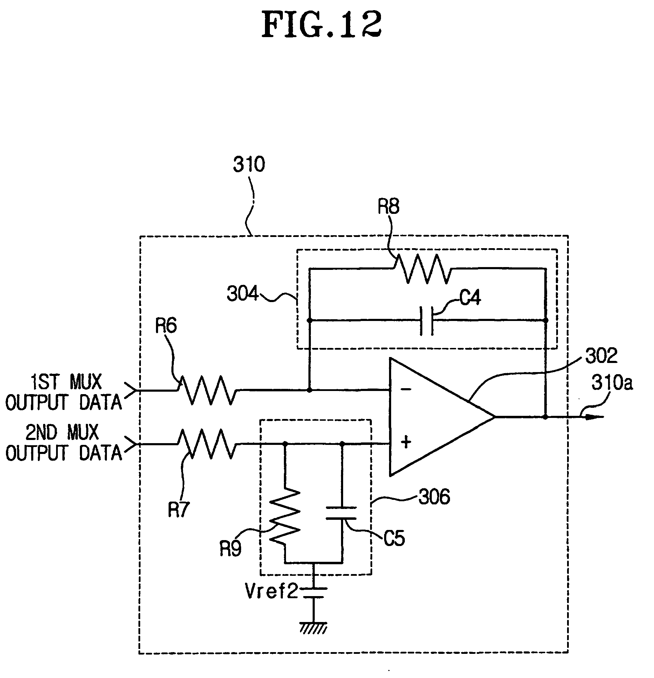

An exemplary construction of the difference detector 310 is shown in Figure 12.

Referring to Figure 12, the difference detector 310 includes resistors R6 and R7, an OP-amp 302, and RC parallel circuits 304 and 306.

The resistor R6 is connected between the output line 100a of the first multiplexer 130 and an inverse input terminal (-) of the OP-amp 302.

The resistor R7 is connected between the output line 100b of the second multiplexer 140 and the non-inverse input terminal (+) of the OP-amp 302.

The RC parallel circuit 304, in which the resistor R8 and the capacitor C4 are interconnected in parallel, is connected between the inverse input terminal (-) of the OP-amp 302 and the output end 310a of the OP-amp 302.

Further, the RC parallel circuit 306, in which the resistor R9 and the capacitor C5 are interconnected in parallel, is connected between the non-inverse input terminal (+) of the OP-amp 302 and the resistor R7.

A value for a reference voltage source (Vref2) connected to one end of the RC parallel circuit 306 is decided appropriately.

Through the output end 310a of the difference detector 310, a signal, which corresponds to the difference between the signals output from the first and the second multiplexers 130 and 140, is output.

The comparator 320 compares the signal output from the difference detector 310 with the reference voltage source (Vref1), and outputs the comparison result.

Accordingly, through the comparator 320, a DC-deleted demodulated signal in the form of pulse wave is output.

Although the present invention is applied to the case where the sixteen times multiplied reference clocks are generated, if the sampling rate is set differently, the number of the running clocks and output lines can be varied accordingly.

As described above, by the data slicer and the RF receiver employing the data slicer in accordance with the present invention, and since the digital data in the pulse form can be obtained from the DC-deleted signal of the demodulated data signal, the signal recovery efficiency is improved.

Although the preferred embodiments of the present invention have been described, it is understood that the present invention should not be limited to these preferred embodiments but various changes and modifications can be made by one skilled in the art within the scope of the present invention as hereinafter claimed

The reader's attention is directed to all papers and documents which are filed concurrently with or previous to this specification in connection with this application and which are open to public inspection with this specification.

## Claims

1. A data slicer (100) comprising:
a sample signal output portion (101) for outputting a first sample signal by sequentially outputting samples of demodulated input signals that are sampled according to a predetermined sampling frequency, and outputting a second sample signal which is sampled at a predetermined time delayed from the first sample signal;
**characterised by** a data recovery portion (200; 300) for recovering the demodulated input signals into a DC offset component-deleted signal, by using the first and the second sample signals output from the sample signal output portion.

2. The data slicer of claim 1, wherein the sample signal output portion (101) comprises:
a running clock generator (110) for sequentially generating a running clock corresponding to the sampling frequency of output channels, a cyclic period of the running clock being set by multiplying a predetermined number by a unit data interval of the demodulated input signals;
a sampler (120) synchronized with the respective running clocks output from the running clock generator (110), for sampling and holding the demodulated input signals;
a first multiplexer (130) for synchronizing samples held by the sampler (120) to the respective running clocks, and outputting the result as the first sample signal; and
a second multiplexer (140) for synchronizing the samples that are held by the sampler (120) ahead of the samples output from the first multiplexer (130) at a predetermined time interval, and outputting the result as the second sample signal.

3. The data slicer of claim 2, wherein the cyclic period of the running clocks output from the running clock generator (120) is two times longer than the unit data interval of the demodulated input signals.

4. The data slicer of claim 3, wherein the sampler (120) comprises:
a plurality of switches (121) connected in parallel with an input line of the demodulated input signals, the plurality of switches (121) being switched on/off according to corresponding running clocks; and
a holding portion (122) for holding signals input through the plurality of switches (121).

5. The data slicer of claim 4, wherein the holding portion (122) comprises a plurality of capacitors connected with the plurality of switches, respectively.

6. The data slicer of any preceding claim, wherein the data recovery portion (200) comprises:
a difference detector (210) for obtaining a difference signal from a difference between the first and the second sample signals, and outputting the difference signal and its inversed signal, respectively; and
a comparator (220) for comparing the difference signal and the inversed signal output through the difference detector (210), and outputting a comparison result as a pulse type data signal.

7. The data slicer of claim 6, wherein the difference detector (210) comprises:
a first resistor (R2), one end of which is connected to an output path of the first sample signal;
a second resistor (R3), one end of which is connected to an output path of the second sample signal;
an OP-amp (202), a non-inverse input terminal and an inverse input terminal of which are connected to the other ends of the first and the second resistors (R2,R3), respectively wherein, the OP-amp (202) outputs signals through an inverse output terminal and a non-inverse output terminal, respectively;
a first RC parallel circuit (204) connected between the non-inverse input terminal and the inverse output end of the OP-amp (202), and a second RC parallel circuit (206) connected between the inverse input terminal and the non-inverse output terminal of the OP-amp (202).

8. The data slicer of any of claims 1 through 5, wherein the data recovery portion (300) comprises:
a difference detector (310) for outputting a signal from a difference between the first and the second sample signals; and
a comparator (320) for comparing the difference signal output from the difference detector (310) with a predetermined reference voltage, and outputting a comparison result as a pulse data signal.

9. The data slicer of claim 8, wherein the difference detector (310) comprises:
a third resistor (R6), one end of which is connected to an output path of the first sample signal;
a fourth resistor (R7), one end of which is connected to an output path of the second sample signal;
an OP-amp (302), an inverse input terminal and a non-inverse input terminal of which are connected with the other ends of the third and the fourth resistors (R6,R7), wherein the OP-amp (302) compares the signals input to the inverse input terminal and the non-inverse input terminal through the other ends of the third and the fourth resistors (R6,R7), and outputs a comparison result through an output terminal of the OP-amp (302);
a third RC parallel circuit (304) connected between the inverse input terminal of the OP-amp (302) and the output terminal of the OP-amp (302); and
a fourth RC parallel circuit (306) connected between the non-inverse input terminal of the OP-amp (302) and a reference voltage source (Vref2).

10. The data slicer of claim 1, wherein:
the data recovery portion (200) recovers the demodulated input signals into a DC offset component-deleted signal by obtaining a difference signal from a difference between the first and the second sample signals, and inversing the difference signal, and comparing the inversed difference signal with the difference signal, and outputting a comparison result.

11. The data slicer of claim 1, wherein:
the data recovery portion (300) recovers the demodulated input signals into a DC offset component-deleted signal by obtaining a difference signal from a difference between the first and the second sample signals, and comparing the difference signal with a predetermined reference signal, and outputting a comparison result.

12. An RF receiver (50), comprising:
a demodulator (90) for demodulating a received RF signal; and
a data slicer (100) according to claim 1 for recovering a demodulated signal input from the demodulator into a pulse data signal.

13. The RF receiver of claim 12, further comprising:
an amplifier (70) for amplifying the RF signal; and
a mixer (80) for mixing the signal amplified by the amplifier (70) with a predetermined oscillating signal, and outputting a mixed result to the demodulator (90).

## Revendications

1. Dispositif de découpage de données (100) comprenant :
une partie de sortie de signal échantillon (101) pour sortir un premier signal échantillon en sortant séquentiellement des échantillons de signaux d'entrée démodulés qui sont échantillonnés selon une fréquence d'échantillonnage prédéterminée, et pour sortir un second signal échantillon qui est échantillonné à un instant prédéterminé retardé par rapport au premier signal échantillon ;
**caractérisé par** une partie de récupération de données (200 ; 300) pour récupérer les signaux d'entrée démodulés en un signal à composante continue de décalage effacée, en utilisant les premier et second signaux échantillons sortis en provenance de la partie de sortie de signal échantillon.

2. Dispositif de découpage de données selon la revendication 1, dans lequel la partie de sortie de signal échantillon (101) comprend :
un générateur d'horloge de fonctionnement (110) pour produire séquentiellement une horloge de fonctionnement correspondant à la fréquence d'échantillonnage de canaux de sortie, une période cyclique de l'horloge de fonctionnement étant fixée en multipliant un nombre prédéterminé par un intervalle de données unitaire des signaux d'entrée démodulés ;
un échantillonneur (120) synchronisé avec les horloges de fonctionnement respectives sorties en provenance du générateur d'horloge de fonctionnement (110), pour échantillonner et maintenir les signaux d'entrée démodulés ;
un premier multiplexeur (130) pour synchroniser des échantillons maintenus par l'échantillonneur (120) avec les horloges de fonctionnement respectives, et pour sortir le résultat en tant que premier signal échantillon ; et
un second multiplexeur (140) pour synchroniser les échantillons qui sont maintenus par l'échantillonneur (120) en avant des échantillons sortis du premier multiplexeur (130) à un intervalle de temps prédéterminé, et pour sortir le résultat en tant que second signal échantillon.

3. Dispositif de découpage de données selon la revendication 2, dans lequel la période cyclique des horloges de fonctionnement sorties en provenance du générateur d'horloge de fonctionnement (120) est deux fois plus longue que l'intervalle de données unitaire des signaux d'entrée démodulés.

4. Dispositif de découpage de données selon la revendication 3, dans lequel l'échantillonneur (120) comprend :
plusieurs commutateurs (121) reliés en parallèle à une ligne d'entrée des signaux d'entrée démodulés, les plusieurs commutateurs (121) étant commutés en marche / arrêt selon des horloges de fonctionnement correspondantes ; et
une partie de maintien (122) pour maintenir des signaux entrés par les plusieurs commutateurs (121).

5. Dispositif de découpage de données selon la revendication 4, dans lequel la partie de maintien (122) comprend plusieurs condensateurs respectivement reliés aux plusieurs commutateurs.

6. Dispositif de découpage de données selon l'une quelconque des revendications précédentes, dans lequel la partie de récupération de données (200) comprend :
un détecteur de différence (210) pour obtenir un signal de différence à partir d'une différence entre les premier et second signaux échantillons, et pour respectivement sortir le signal de différence et son signal inversé ; et
un comparateur (220) pour comparer le signal de différence et le signal inversé sorti par le détecteur de différence (210), et pour sortir un résultat de comparaison en tant que signal de données de type impulsion.

7. Dispositif de découpage de données selon la revendication 6, dans lequel le détecteur de différence (210) comprend :
une première résistance (R2), dont une extrémité est reliée à un chemin de sortie du premier signal échantillon ;
une deuxième résistance (R3), dont une extrémité est reliée à un chemin de sortie du second signal échantillon ;
un amplificateur opérationnel (202), dont une borne d'entrée non inverseuse et une borne d'entrée inverseuse sont respectivement reliées aux autres extrémités des première et deuxième résistances (R2, R3), dans lequel l'amplificateur opérationnel (202) sort respectivement des signaux par l'intermédiaire d'une borne de sortie inverseuse et d'une borne de sortie non inverseuse ;
un premier circuit parallèle RC (204) relié entre la borne d'entrée non inverseuse et l'extrémité de sortie inverseuse de l'amplificateur opérationnel (202), et un second circuit parallèle RC (206) relié entre la borne d'entrée inverseuse et la borne de sortie non inverseuse de l'amplificateur opérationnel (202).

8. Dispositif de découpage de données selon l'une quelconque des revendications 1 à 5, dans lequel la partie de récupération de données (300) comprend :
un détecteur de différence (310) pour sortir un signal à partir d'une différence entre les premier et second signaux échantillons ; et
un comparateur (320) pour comparer le signal de différence sorti en provenance du détecteur de différence (310) à une tension de référence prédéterminée, et pour sortir un résultat de comparaison en tant que signal de données à impulsion.

9. Dispositif de découpage de données selon la revendication 8, dans lequel le détecteur de différence (310) comprend :
une troisième résistance (R6), dont une extrémité est reliée à un chemin de sortie du premier signal échantillon ;
une quatrième résistance (R7), dont une extrémité est reliée à un chemin de sortie du second signal échantillon ;
un amplificateur opérationnel (302), dont une borne d'entrée inverseuse et une borne d'entrée non inverseuse sont reliées aux autres extrémités des troisième et quatrième résistances (R6, R7), dans lequel l'amplificateur opérationnel (302) compare les signaux entrés dans la borne d'entrée inverseuse et la borne d'entrée non inverseuse par les autres extrémités des troisième et quatrième résistances (R6, R7), et sort un résultat de comparaison par une borne de sortie de l'amplificateur opérationnel (302) ;
un troisième circuit parallèle RC (304) relié entre la borne d'entrée inverseuse de l'amplificateur opérationnel (302) et la borne de sortie de l'amplificateur opérationnel (302) ; et
un quatrième circuit parallèle RC (306) relié entre la borne d'entrée non inverseuse de l'amplificateur opérationnel (302) et une source de tension de référence (Vref2).

10. Dispositif de découpage de données selon la revendication 1, dans lequel :
la partie de récupération de données (200) récupère les signaux d'entrée démodulés en un signal à composante continue de décalage effacée en obtenant un signal de différence à partir d'une différence entre les premier et second signaux échantillons, et en inversant le signal de différence, et en comparant le signal de différence inversé au signal de différence, et en sortant un résultat de comparaison.

11. Dispositif de découpage de données selon la revendication 1, dans lequel :
la partie de récupération de données (300) récupère les signaux d'entrée démodulés en un signal à composante continue de décalage effacée en obtenant un signal de différence à partir d'une différence entre les premier et second signaux échantillons, et en comparant le signal de différence à un signal de référence prédéterminé, et en sortant un résultat de comparaison.

12. Récepteur à haute fréquence (50), comprenant :
un démodulateur (90) pour démoduler un signal à haute fréquence reçu ; et
un dispositif de découpage de données (100) selon la revendication 1 pour récupérer un signal démodulé entré en provenance du démodulateur en un signal de données à impulsion.

13. Récepteur à haute fréquence selon la revendication 12, comprenant en outre :
un amplificateur (70) pour amplifier le signal à haute fréquence ; et
un mélangeur (80) pour mélanger le signal amplifié par l'amplificateur (70) avec un signal oscillant prédéterminé, et pour sortir un résultat mélangé vers le démodulateur (90).

## Patentansprüche

1. Daten-Slicer (100), umfassend:
einen Abtastsignal-Ausgangsabschnitt (101) zum Ausgeben eines ersten Abtastsignals durch ein sequentielles Ausgeben von Abtastwerten von demodulierten Eingangssignalen, die gemäß einer vorbestimmten Abtastfrequenz abgetastet sind, und zum Ausgeben eines zweiten Abtastsignals, das zu einer vorbestimmten Zeit, die von dem ersten Abtastsignal verzögert ist, abgetastet ist;
**gekennzeichnet durch** einen Datenwiedergewinnungsabschnitt (200; 300) zum Wiedergewinnen der demodulierten Eingangssignale in ein Gleichspannungs-Offsetkomponenten-freies Signal, indem die ersten und zweiten Abtastsignale verwendet werden, die aus dem Abtastsignal-Ausgangsabschnitt ausgegeben werden.

2. Daten-Slicer nach Anspruch 1, wobei der Abtastsignal-Ausgangsabschnitt (101) umfasst:
einen Freilauftaktgenerator (110) zum sequentiellen Erzeugen eines Freilauftakts, der der Abtastfrequenz der Ausgangskanäle entspricht, wobei eine Zyklusperiode des Freilauftakts durch ein Multiplizieren einer vorbestimmten Zahl mit einem Einheitsdatenintervall der demodulierten Eingangssignale eingestellt ist;
eine Abtasteinheit (120), die mit den jeweiligen Freilauftakten synchronisiert ist, die aus dem Freilauftaktgenerator (110) ausgegeben werden, zum Abtasten und Halten der demodulierten Eingangssignale;
einen ersten Multiplexer (130) zum Synchronisieren von Abtastwerten, die von der Abtasteinheit (120) gehalten werden, mit den jeweiligen Freilauftakten und zum Ausgeben des Ergebnisses als das erste Abtastsignal;
einen zweiten Multiplexer (140) zum Synchronisieren der Abtastwerte, die von der Abtasteinheit (120) gehalten werden, zu einem vorbestimmten Zeitintervall vor den Abtastwerten, die von dem ersten Multiplexer (130) ausgegeben werden, und zum Ausgeben des Ergebnisses als das zweite Abtastsignal.

3. Daten-Slicer nach Anspruch 2, wobei die Zyklusperiode der Freilauftakte, die aus dem Freilauftaktgenerator (120) ausgegeben werden, zweimal länger als das Einheitsdatenintervall der demodulierten Eingangssignale ist.

4. Daten-Slicer nach Anspruch 3, wobei die Abtasteinheit (120) umfasst:
eine Mehrzahl von Schaltern (121), die parallel mit einer Eingangsleitung der demodulierten Eingangssignale verbunden sind, wobei die Mehrzahl von Schaltern (121) gemäß der entsprechenden Freilauftakte ein/ausgeschaltet werden; und
einen Halteabschnitt (122) zum Halten von Signalen, die über die Mehrzahl von Schaltern (121) eingegeben werden.

5. Daten-Slicer nach Anspruch 4, wobei der Halteabschnitt (121) eine Mehrzahl von Kondensatoren umfasst, die jeweils mit der Mehrzahl von Schaltern verbunden sind.

6. Daten-Slicer nach einem voranstehenden Anspruch, wobei der Datenwiedergewinnungsabschnitt (200) umfasst:
einen Differenzdetektor (210) zum Erhalten eines Differenzsignals aus einer Differenz zwischen den ersten und zweiten Abtastsignalen und zum Ausgeben des Differenzsignals bzw. seines invertierten Signals; und
einen Komparator (220) zum Vergleichen des Differenzsignals und des invertierten Signals, die über den Differenzdetektor (210) ausgegeben werden, und zum Ausgeben eines Vergleichsergebnisses als ein Datensignal vom Pulstyp.

7. Daten-Slicer nach Anspruch 6, wobei der Differenzdetektor (210) umfasst:
einen ersten Widerstand (R2), wovon ein Ende mit einem Ausgangspfad des ersten Abtastsignals verbunden ist;
einen zweiten Widerstand (R3), wovon ein Ende mit einem Ausgangspfad des zweiten Abtastsignals verbunden ist;
einen Operationsverstärker (202), dessen nichtinvertierender Eingangsanschluss und dessen invertierender Eingangsanschluss mit den anderen Enden der ersten und zweiten Widerstände (R2, R3) jeweils verbunden sind, wobei der Operationsverstärker (202) Signale über einen invertierenden Ausgangsanschluss bzw. einen nicht-invertierenden Ausgangsanschluss ausgibt;
eine erste RC-Parallelschaltung (204), die zwischen dem nicht-invertierenden Eingangsanschluss und dem invertierenden Ausgangsende des Operationsverstärkers (202) verbunden ist, und eine zweite RC-Parallelschaltung (206), die zwischen dem invertierenden Eingangsanschluss und dem nicht-invertierenden Ausgangsanschluss des Operationsverstärkers (202) verbunden ist.

8. Daten-Slicer nach einem der Ansprüche 1 bis 5, wobei der Datenwiedergewinnungsabschnitt (300) umfasst:
einen Differenzdetektor (310) zum Ausgeben eines Signals aus einer Differenz zwischen den ersten und zweiten Abtastsignalen; und
einen Komparator (320) zum Vergleichen des Differenzsignals, das aus dem Differenzdetektor (310) ausgegeben wird, mit einer vorbestimmten Referenzspannung und zum Ausgeben eines Vergleichsergebnisses als ein Pulsdatensignal.

9. Daten-Slicer nach Anspruch 8, wobei der Differenzdetektor (310) umfasst:
einen dritten Widerstand (R6), wovon ein Ende mit einem Ausgangspfad des ersten Abtastsignals verbunden ist;
einen vierten Widerstand (R7), wovon ein Ende mit einem Ausgangspfad des zweiten Abtastsignals verbunden ist;
einen Operationsverstärker (302), wovon ein invertierender Eingangsanschluss und ein nichtinvertierender Eingangsanschluss mit den anderen Enden der dritten und vierten Widerstände (R6, R7) verbunden sind, wobei der Operationsverstärker (302) die Signale, die in den invertierenden Eingangsanschluss und den nicht-invertierenden Eingangsanschluss über die anderen Enden der dritten und vierten Widerstände (R6, R7) eingegeben werden, vergleicht und ein Vergleichsergebnis über einen Ausgangsanschluss des Operationsverstärkers (302) ausgibt;
eine dritte RC-Parallelschaltung (304), die zwischen dem invertierenden Eingangsanschluss des Operationsverstärkers (302) und dem Ausgangsanschluss des Operationsverstärkers (302) verbunden ist; und
eine vierte RC-Parallelschaltung (306), die zwischen dem nicht-invertierenden Eingangsanschluss des Operationsverstärkers (302) und einer Referenzspannungsquelle (Vref2) verbunden ist.

10. Daten-Slicer nach Anspruch 1, wobei:
der Datenwiedergewinnungsabschnitt (200) die demodulierten Eingangssignale in ein'Gleichspannungs-Offsetkomponenten-freies Signal wiedergewinnt, indem ein Differenzsignal aus einer Differenz zwischen den ersten und zweiten Abtastsignalen erhalten wird, und indem das Differenzsignal invertiert wird, und indem das invertierte Differenzsignal mit dem Differenzsignal verglichen wird, und indem ein Vergleichsergebnis ausgegeben wird.

11. Daten-Slicer nach Anspruch 1, wobei:
der Datenwiedergewinnungsabschnitt (300) die demodulierten Eingangssignale in ein Gleichspannungs-Offsetkomponenten-freies Signal wiedergewinnt, indem ein Differenzsignal aus einer Differenz zwischen den ersten und zweiten Abtastsignalen erhalten wird, und indem das Differenzsignal mit einem vorbestimmten Referenzsignal verglichen wird, und ein Vergleichsergebnis ausgegeben wird.

12. HF-Empfänger (50), umfassend:
einen Demodulator (90) zum Demodulieren eines empfangenen HF-Signals; und
einen Daten-Slicer (100) nach Anspruch 1 zum Wiedergewinnen eines demodulierten Signals, das von dem Demodulator eingegeben wird, in ein Pulsdatensignal.

13. HF-Empfänger nach Anspruch 12, weiter umfassend:
einen Verstärker (70) zum Verstärken des HF-Signals; und
einen Mischer (80) zum Mischen des Signals, das von dem Verstärker (70) verstärkt ist, mit einem vorbestimmten Oszillationssignal und zum Ausgeben eines Mischergebnisses zu dem Demodulator (90).
